# EUROPEAN PATENT APPLICATION

(11) **EP 0 535 951 A1**
(43) Date of publication of application: **07.04.1993**
(21) Application number: 92308958.5
(22) Date of filing: 01.10.1992
(51) Int. Cl.: H03F 3/30

(54) **High efficiency push-pull type output circuit and operational amplifier circuit using the same**

(30) Priority: 03.10.1991 JP 256119/91
(71) Applicant: NEC CORPORATION, Tokyo (JP)
(72) Inventor: Yoshihara, Toshio, Minato-ku, Tokyo (JP)
(74) Representative: Moir, Michael Christopher

(57) **Abstract**

A push-pull type output circuit comprises an input differential amplifier stage (11) responsive to an input differential voltage signal, and an output driver stage (12) for driving an external load, wherein the input differential amplifier stage and the output driver stage are implemented by a class AB amplifier circuit (11a/ 11b) and two current mirror circuits (12a/ 12b), respectively, so that the current utilization factor is improved.

## Description

### FIELD OF THE INVENTION

This invention relates to a push-pull type output circuit and to an operational amplifier circuit embodying such a circuit.

### DESCRIPTION OF THE RELATED ART

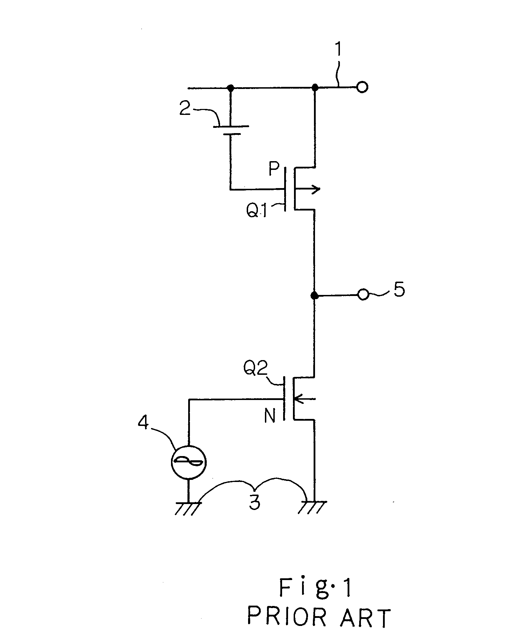

Atypical example of the output circu it is illustrated in Fig. 1, and comprises a p-channel enhancement type field effect transistor Q1 and an n-channel enhancement type field effect transistor Q2 coupled in series with the p-channel enhancement type field effect transistor Q1. The source node of the p-channel enhancement type field effect transistor Q1 is coupled with a positive power source line 1, and the gate electrode thereof is coupled with a constant voltage source 2. The n-channel enhancement type field effect transistor Q2 is coupled at the source node thereof with a ground voltage line 3, and a signal source 4 is coupled with the gate electrode of the n-channel enhancement type field effect transistor Q2. The signal source 4 produces a data signal, and the voltage level of the data signal is variable. The drain nodes of the field effect transistors Q1 and Q2 are coupled with one another, and serve as an output node 5 of the output circuit.

The prior art output circuit thus arranged behaves as follows. The p-channel enhancement type field effect transistor Q1 serves as a constant current source, and the n-channel enhancement type field effect transistor Q2 varies the amount of current passing therethrough depending upon the voltage level at the gate electrode thereof. If the data signal goes down toward a low voltage level, the current from the p-channel enhancement type field effect transistor is partially supplied to a load (not shown) coupled with the output node 5, and the remaining current is discharged through the n-channel enhancement type field effect transistor Q2 to the ground voltage line 3.

On the other hand, if the data signal goes up toward a high voltage level, the n-channel enhancement type field effect transistor Q2 allows all the current from the p-channel enhancement type field effect transistor Q1 as well as current from the load to flow into the ground voltage line 3.

However, a problem is encountered in the prior art output circuit in that a large amount of heat is generated therefrom, and, for this reason, the prior art output circuit is hardly integrated into a large scale integration. This is because of the fact that the constant current from the p-channel enhancement type field effect transistor deteriorates the current utilization factor.

### SUMMARY OF THE INVENTION

It is therefore an important object of the present invention provide an output circuit which is improved in current utilization factor.

To accomplish the object, the present invention proposes to use a class AB differential amplifier for controlling an output driver stage.

In accordance with the present invention, there is provided a push-pull type output circuit comprising:
a) an input differential amplifier stage having a-1) a first current mirror circuit coupled between a first power voltage source and a combination of a first control node and a first output node, and responsive to first control voltage level at the first control node for controlling first and second branch currents respectively flowing into the first control node and the first output node, the amount of the first branch current being larger than the amount of the second branch current, a-2) a first input differential circuit coupled between the combination of the first control node and the first output node and a second power voltage source, and responsive to an input differential voltage signal for controlling the first control voltage level, the total amount of current flowing out from the first input differential circuit being constant, a-3) a second input differential circuit coupled between the first power voltage source and a combination of a second control node and a second output node, and responsive to the input differential voltage signal for controlling second control voltage level at the second control node, the total amount of current flowing out from the second input differential circuit being constant, and a-4) a second current mirror circuit coupled between the combination of the second control node and the second output node and the second power voltage source, and responsive to the second control voltage level for controlling third and fourth branch currents respectively supplied from the second control node and the second output node, the amount of the third branch current being larger than the amount of the fourth branch current; and b) an output driver stage having b-1) a third current mirror circuit coupled between the first power voltage source and a third output node coupled with an external load, and responsive to voltage level at the first output node for controlling current supplied to the first output node, and b-2) a fourth current mirror circuit coupled between the third output node and the second power voltage source, and responsive to voltage level at the second output node for controlling current supplied from the second control node thereto, the third and fourth current mirror circuits driving the external load.

In accordance with another aspect of the present invention, there is provided an operational amplifier circuit comprising: a) an input differential amplifier unit responsive to an input differential voltage signal for producing an output differential voltage signal; and b) a push-pull output unit comprising b-1) an input differential amplifier stage having b-1-1) a first current mirror circuit coupled between a first power voltage source and a combination of a first control node and a first output node, and responsive to first control voltage level at the first control node for controlling first and second branch currents respectively flowing into the first control node and the first output node, the amount of the first branch current being larger than the amount of the second branch current, b-1-2) a first input differential circuit coupled between the combination of the first control node and the first output node and a second power voltage source, and responsive to the output differential voltage signal for controlling the first control voltage level, the total amount of current flowing out from the first input differential circuit being constant, b-1-3) a second input differential circuit coupled between the first power voltage source and a combination of a second control node and a second output node, and responsive to the output differential voltage signal for controlling second control voltage level at the second control node, the total amount of current flowing out from the second input differential circuit being constant, and b-1-4) a second current mirror circuit coupled between the combination of the second control node and the second output node and the second power voltage source, and responsive to the second control voltage level for controlling third and fourth branch currents respectively supplied from the second control node and the second output node, the amount of the third branch current being larger than the amount of the fourth branch current, and b-2) an output driver stage having b-2-1) a third current mirror circuit coupled between the first power voltage source and a third output node coupled with an external load, and responsive to voltage level at the first output node for controlling current supplied to the first output node, and b-2-2) a fourth current mirror circuit coupled between the third output node and the second power voltage source, and responsive to voltage level at the second output node for controlling current supplied from the second control node thereto, the third and fourth current mirror circuits driving the external load.

### BRIEF DESCRIPTION OF THE DRAWINGS

The feature and advantages of the output circuit according to the present invention will be more clearly understood from the following description taken in conjunction with the accompanying drawings in which:
Fig. 1 is a circuit diagram showing the arrangement of the prior art output circuit;
Fig. 2 is a circuit diagram showing the circuit arrangement of an output circuit according to the present invention; and
Fig. 3 is a circuit diagram showing the arrangement of an operational amplifier circuit according to the present invention.

### DESCRIPTION OF THE PREFERRED

### EMBODIMENT

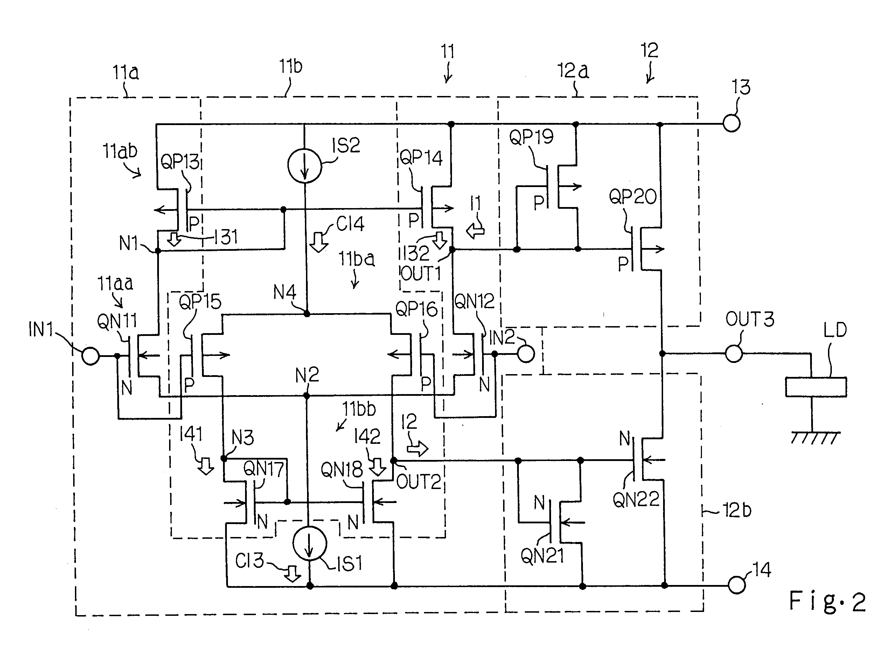

Referring to Fig. 2 of the drawings, a push-pull type output circuit embodying the present invention is largely comprises a class AB input amplifier stage 11 with a pair of output nodes OUT1 and OUT2, and an output driver stage 12 for driving an external load LD coupled with an output node OUT3 thereof.

The input amplifier stage 11 is broken down into a first differential amplifier circuit 11a and a second differential amplifier circuit 11b. An inverted input node IN1 and a non-inverted input node IN2 are shared between the first and second differential amplifier circuits 11a and 11b, and the first and second amplifier circuits 11a and 11b are respectively associated with the output nodes OUT1 and OUT2. The inverted input node IN1 and the non-inverted input node IN2 are determined with respect to the output node OUT3. Current 11 flows from the output driver stage 12 into the output node OUT1 of the first differential amplifier circuit 11a, and current 12 flows out from the output node OUT2 of the second differential amplifier circuit 11 b to the output driver stage 12.

The first differential amplifier circuit 11 a comprises a first input differential circuit 11aa and a first current mirror circuit 11ab. The first input differential circuit 11aa is fabricated from a pair of n-channel enhancement type input transistors QN11 and QN12 as well as a first constant current source IS1, and the first current mirror circuit 11ab is implemented by a parallel combination of p-channel enhancement type load transistors QP13 and QP14. The p-channel enhancement type load transistors QP13 and QP14 are coupled at the source nodes thereofwith a first power voltage source 13, and the gate electrodes thereof are coupled with the drain node N1 of the p-channel enhancement type load transistor QP13. The drain node N1 serves as a first control node, and the drain node of the p-channel enhancement type load transistor QP14 serves as the output node OUT1. The channel resistances of the p-channel enhancement type load transistors QP13 and QP14 are varied with the voltage level at the drain node N1, and supply first and second branch currents 131 and 132 to the drain node N1 and the output node OUT1, respectively. The first current mirror circuit 11ab is arranged in such a manner that the amount of the first branch current 131 is larger than the amount of the second branch current 132. The n-channel enhancement type input transistors QN11 and QN12 are coupled in parallel between the first current mirror circuit 11ab and a common drain node N2, and the input nodes IN1 and IN2 are coupled with the gate electrodes of the n-channel enhancement type input transistors QN11 and QN12. The first constant current source IS1 is coupled between the common drain node N2 and a second power voltage source 14 lower in voltage level than the first power voltage source 13, and allows constant current CI3 to flow into the second power voltage source 14.

The second differential amplifier circuit 11b b comprises a second input differential circuit 11 ba and a second current mirror circuit 11 bb. The second input differential circuit 11ba is fabricated from a pair of p-channel enhancement type input transistors QP15 and QP16 as well as a second constant current source IS2, and the second current mirror circuit 11 bb is implemented by a parallel combination of n-channel enhancement type load transistors QN17 and QN18. The n-channel enhancement type load transistors QN17 and QN18 are coupled at the source nodes t hereof wit h t he second power voltage source 14, and the gate electrodes thereof are coupled with the drain node N3 of the n-channel enhancement type load transistor QN17. the second current mirror circuit 11 bb is responsive to voltage level at the drain node N3, and controls the channel resistances of the n-channel enhancement type load transistors QN17 and QN18 so thatthird and fourth branch currents 141 and 142 are discharged to the second power voltage source 14. The drain node N3 serves as a second control node, and the drain node of the n-channel enhancement type load transistor QN18 serves as the output node OUT2. The second current mirror circuit 11bb is also arranged in such a manner that the amount of the third branch current 141 is larger than the amount of fourth branch current 142. The p-channel enhancement type input transistors QP15 and QP16 are coupled in parallel between a common drain node N4 and the second current mirror circuit 11 bb, and the input nodes IN1 and IN2 are also coupled with the gate electrodes of the p-channel enhancement type input transistors QP15 and QP16. The second constant current source IS2 is coupled between the first power voltage source 13 and the common drain node N4, and allows constant current CI4 to flow from the first power voltage source 13 to the parallel combination of the p-channel enhancement type input transistors QP15 and QP16. As described hereinbefore, the first current mirror circuit 11ab controls the first branch current 131 more than the second branch current 132, and the first and second differential circuits 11 a and 11b b allow respective offsets to opposite polarities to take place. The first and second current mirrorcircuits 11ab and 11 bb thus arranged allow the input amplifier stage 11 to operate in the class AB.

The output driver stage 12 comprises third and fourth current mirror circuits 12a and 12b, and the output node OUT3 is coupled between the third and fourth current mirror circuits 12a and 12b. The third current mirror circuit 12a is fabricated from a p-channel enhancement type current-source transistor QP19 and a p-channel enhancement type driver transistor QP20. The p-channel enhancement type current-source transistor QP19 is coupled between the first power voltage source 13 and the output node OUT1, and the output node OUT1 is further coupled with the gate electrode of the p-channel enhancement type current-source transistor QP19. The p-channel enhancement type driver transistor QP20 is coupled between the first power voltage source 13 and the output node OUT3, and the gate electrode thereof is coupled with the output node OUT1. The p-channel enhancement type current-source transistor QP19 is responsive to the voltage level at the output node OUT1, and supplies the current 11 to the output node OUT1. The fourth current mirror circuit 12b is fabricated from an n-channel enhancement type current-source transistor QN21 and an n-channel enhancement type driver transistor QN22. The n-channel enhancement type current-source transistor QN21 is coupled between the output node OUT2 and the second power voltage source 14, and the output node OUT2 is further coupled with the gate electrode of the n-channel enhancement type current-source transistor QN21. The n-channel enhancement type driver transistor QN22 is coupled between the output node OUT3 and the second power voltage source 14, and the gate electrode thereof is coupled with the output node OUT2. The n-channel enhancement type current-source transistor QN21 is responsive to the voltage level at the output node OUT2, and discharges the current 12 into the second power voltage source 14. the n-channel enhancement type driver transistor QN22 is responsive to the voltage level at the output node OUT2, and the p-channel enhancement type driver transistor QP20 and the n-channel enhancement type driver transistor QN22 drives the external load LD in a push-pull type manner. If driving currents respectively passing through the driving transistors Qp20 and QN22 are approximately equal in absolute value to one another, the driving current is indicative of idling current at zero output.

The present inventor simulated the circuit behavior of the push-pull type output circuit according to the present invention with a simulation program "SPICE". Power voltage of 5 volts was supplied to the power voltage line 13, and the other power voltage line was grounded. The push-pull output circuit swung the output node OUT3 within 3 volts at peak-to-peak, and drove the external load LD of 20 ohms. The idling current was 7 milli-amperes, and the gain was 26 dB. In the same condition, the prior art output circuit shown in Fig. 1 merely achieved 26 dB, and drove the external load of 20 ohms with the output voltage signal of 3 volts at peak-to-peak. The idling current was 80 milli-amperes. Therefore, it is understood that the push-pull output circuit implementing the present invention effectively decreases the idling current.

Description is briefly made on the circuit behavior of the push-pull type output circuit. Assuming now that the voltage level at the input node IN1 becomes lower than that at the other input node IN2, the n-channel enhancement type input transistor QN11 increases the channel resistance thereof, and, on the other hand, the p-channel enhancement type input transistor QP15 decreases the channel resistance thereof. The n-channel enhancement type input transistor QN11 thus increasing the channel resistance causes the voltage level at the drain node N1 to go up, and the first current mirror circuit 11ab decreases the first and second branch currents 131 and 132. As a result, the current 11 is increased, and the p-channel enhancement type driver transistor decreases the channel resistance thereof.

On the other hand, the p-channel enhancement type input transistor QP15 causes the drain node N3 to go up, and the second current mirror circuit 11 bb increases the third and fourth currents 141 and 142. As a result, the amount of current 12 is decreased, and causes, accordingly, the n-channel enhancement type driver transistor QN22 to increase the channel resistance thereof. For this reason, the voltage level at the output node OUT3 rises, and drives the external load LD.

However, if the voltage level atthe input node IN1 becomes higher than that at the other input node IN2, the n-channel enhancement type input transistor QN11 decreases the channel resistance thereof, and, on the other hand, the p-channel enhancement type input transistor QP15 increases the channel resistance thereof. The n-channel enhancement type input transistor QN11 thus decreasing the channel resistance causes the voltage level at the drain node N1 to go down, and the first current mirror circuit 11ab increases the first and second branch currents 131 and 132. As a result, the current 11 is decreased, and the p-channel enhancement type driver transistor increases the channel resistance thereof.

On the other hand, the p-channel enhancement type input transistor QP15 causes the drain node N3 to go down, and the second current mirror circuit 11 bb decreases the third and fourth currents 141 and 142. As a result, the amount of current 12 is increased, and causes, accordingly, the n-channel enhancement type driver transistor QN22 to decrease the channel resistance thereof. Therefore, the voltage level at the output node OUT3 is decayed, and takes up current from the external load LD.

As will be understood from the foregoing description, the push-pull type output circuit according to the present invention decreases the current utilization factor by virtue of the input differential amplification stage. Moreover, since the output driver stage is implemented by two current mirror circuits, the output driver stage 12 widely swings the output voltage level at the output node OUT3.

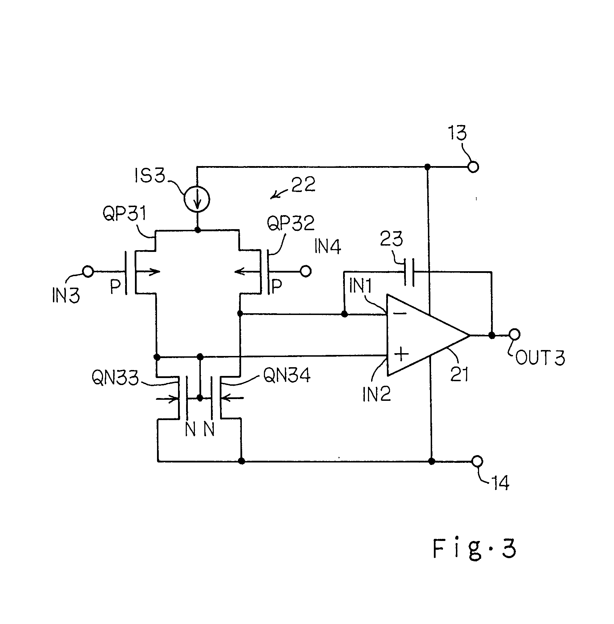

The push-pull type output circuit is preferable for an operational amplifier circuit, and the circuit arrangement of an operational amplifier circuit according to the present invention is illustrated in Fig. 3. Reference numeral 21 designates the push-pull type output circuit shown in Fig. 2, and an input differential amplifier unit 22 is provided in association with the push-pull type output circuit 21. A phase compensating capacitor 23 is coupled between the output node OUT3 and the input node IN1. The input differential amplifier unit 22 comprises a constant current source IS3 coupled with the power voltage source 13, and two series combination of p-channel enhancement type amplifying transistors QP31 and QP32 and n-channel enhancement type load transistors QN33 and QN34 coupled between the constant current source IS3 and the power voltage line 14. An input differential voltage signal is applied from input nodes IN3 and IN4 to the gate electrodes of the p-channel enhancement type amplifying transistors QP31 and QP32, and the gate electrodes of the load transistors QN33 and QN34 are coupled with the drain node of the load transistor QN33. The input differential amplifier unit 22 thus arranged is responsive to the input differential voltage signal between the input nodes IN3 and IN4, and develops it as the input differential voltage signal at the input nodes IN1 and IN2. With the input differential voltage signal thus developed, the push-pull type output circuit 21 drives the external load as described hereinbefore.

Although a particular embodiment of the present invention has been shown and described, it will be obvious to those skilled in the art that various changes and modifications may be made without departing from the spirit and scope of the present invention. For example, various circuit arrangements may be employed for the input differential amplifier unit 22.

## Claims

1. A push-pull type output circuit comprising an output driver unit for driving an external load (LD), characterized by
a) an input differential amplifier stage (11) having
a-1) a first current mirror circuit (11ab) coupled between a first power voltage source (13) and a combination of a first control node (N1) and a first output node (OUT1), and responsive to first control voltage level at said first control node for controlling first and second branch currents (131/ 132) respectively flowing into said first control node and said first output node, the amount of said first branch current being larger than the amount of said second branch current,
a-2) a first input differential circuit (11aa) coupled between the combination of said first control node and said first output node and a second power voltage source (14), and responsive to an input differential voltage signal for controlling said first control voltage level, the total amount of current (CI3) flowing out from said first inputdiffer- ential circuit being constant,
a-3) a second input differential circuit (11ba) coupled between said first power voltage source and a combination of a second control node (N3) and a second output node (OUT2), and responsive to said input differential voltage signal for controlling second control voltage level at said second control node, the total amount of current (CI4) flowing out from said second input differential circuit being constant, and a-4) a second current mirror circuit (11 bb) coupled between the combination of said second control node and said second output node and said second power voltage source, and responsive to said second control voltage level for controlling third and fourth branch currents respectively supplied from said second control node and said second output node, the amount of said third branch current being larger than the amount of said fourth branch current,
and in that said output driver comprises
b-1) a third current mirror circuit (12a) coupled between said first power voltage source and a third output node (OUT3) coupled with said external load, and responsive to voltage level at said first output node for controlling current (11) supplied to said first output node, and
b-2) a fourth current mirror circuit (12b) coupled between said third output node and said second power voltage source, and responsive to voltage level at said second output node for controlling current (12) supplied from said second control node thereto, said third and fourth current mirror circuits driving said external load.

2. A push-pull type output circuit as set forth in claim 1, in which said first current mirror circuit comprises a parallel combination of first and second enhancement type load transistors (QP13/ QP14) of first channel conductivity type (P) having respective source nodes coupled with said first power voltage source, and respective gate electrodes coupled with a drain node of said first enhancement type load transistor, the drain nodes of said first and second enhancement type load transistors respectively serving as said first control node and said first output node.

3. A push-pull type output circuit as set forth in claim 2, in which said first input differential circuit comprises a first constant current source (IS1) coupled with said second power voltage source, and a parallel combination of third and fourth enhancement type input transistors (QN11/QN12) of second channel conductivity type (N) opposite to said first channel conductivity type, said third and fourth enhancement type input transistors having respective gate electrodes applied with said input differential voltage signal, and respective source-to-drain paths coupled between said parallel combination of said third and second enhancement type load transistors and said first constant current source.

4. A push-pull type output circuit as set forth in claim 3, in which said second input differential circuit comprises a second constant current source (IS2) coupled with said first power voltage source, and a parallel combination of fifth and sixth enhancement type input transistors (QP15/ QP16) of said first channel conductivity type having gate electrodes applied with said input differential voltage signal and respective source-to-drain current paths coupled between said second constant current source and said second current mirror circuit.

5. A push-pull type output circuit as set forth in claim 4, in which said second current mirror circuit comprises a parallel combination of said seventh and eighth enhancement type load transistors (QN17/ QN18) of said first channel conductivity type having respective source nodes coupled with said second power voltage source, and gate electrodes coupled with a drain node of said seventh enhancement type load transistor, the drain nodes of said seventh and eighth enhancement type load transistors serving as said second control node and said second output node.

6. A push-pull type output circuit as set forth in any preceding claim, in which said third current mirror circuit (12a) comprises a ninth enhancement type current source transistor (QP19) of a first channel conductivity type having a gate electrode coupled with said first output node and a source-to-drain current path coupled between said first power voltage source and said first output node, and a tenth enhancement type driver transistor (QP20) of said first channel conductivity type having a gate electrode coupled with said first output node and a source-to-drain current path coupled between said first power voltage source and said third output node.

7. A push-pull type output circuit as set forth in any preceding claim, in which said fourth current mirror circuit (12b) comprises an eleventh enhancement type current source transistor (QN21) of a second channel conductivity type having a gate electrode coupled with said second output node and a source-to-drain current path coupled between said second output node and said second power voltage source, and a twelfth enhancement type driver transistor (QN22) of said second channel conductivity type having a gate electrode coupled with said second output node and a source-to-drain current path coupled between said third output node and said second powervol- tage source, said second channel conductivity type being opposite to said first channel conductivity type.

8. A push-pull type output circuit as set forth in any preceding claim, in which an input differential amplifier unit (22) is associated with said push-pull type output circuit for producing said input differential voltage signal developed from an original differential voltage signal, a phase compensating capacitor (23) being coupled between said third output node and one of input nodes where said input differential voltage signal is applied, said input differential amplifier unit, said push-pull type output circuit and said phase compensating capacitor as a whole constitute an operational amplifier.

9. An operational amplifier circuit comprising: a) an input differential amplifier unit responsive to an input differential voltage signal for producing an output differential voltage signal; and b) a push-pull output unit comprising b-1) an input differential amplifier stage having b-1-1) a first current mirror circuit coupled between a first power voltage source and a combination of a first control node and a first output node, and responsive to first control voltage level at the first control node for controlling first and second branch currents respectively flowing into the first control node and the first output node, the amount of the first branch current being larger than the amount of the second branch current, b-1-2) a first input differential circuit coupled between the combination of the first control node and the first output node and a second power voltage source, and responsive to the output differential voltage signal for controlling the first control voltage level, the total amount of current flowing out from the first input differential circuit being constant, b-1-3) a second input differential circuit coupled between the first power voltage source and a combination of a second control node and a second output node, and responsive to the output differential voltage signal for controlling second control voltage level at the second control node, the total amount of current flowing out from the second input differential circuit being constant, and b-1-4) a second current mirror circuit coupled between the combination of the second control node and the second output node and the second power voltage source, and responsive to the second control voltage level for controlling third and fourth branch currents respectively supplied from the second control node and the second output node, the amount of the third branch current being larger than the amount of the fourth branch current, and b-2) an output driver stage having b-2-1) a third current mirror circuit coupled between the first power voltage source and a third output node coupled with an external load, and responsive to voltage level at the first output node for controlling current supplied to the first output node, and b-2-2) a fourth current mirror circuit coupled between the third output node and the second pow- ervoltage source, and responsive to voltage level at the second output node for controlling current supplied from the second control node thereto, the third and fourth current mirror circuits driving the external load.
